# EUROPÄISCHE PATENTSCHRIFT

(11) **EP 0 937 374 B1**
(45) Veröffentlichungstag und Bekanntmachung des Hinweises auf die Patenterteilung: **09.08.2000**
(21) Anmeldenummer: 97948726.1
(22) Anmeldetag: 07.11.1997
(51) Int. Cl.: H05K 7/14

(54) **BAUGRUPPENTRÄGER MIT MINDESTENS EINER FRONTSEITIGEN VERTIKALEN MONTAGENUT**
SUB-RACK WITH AT LEAST ONE FRONT-SIDED VERTICAL ASSEMBLY GROOVE
BATI ELECTRONIQUE COMPORTANT AU MOINS UNE RAINURE DE MONTAGE VERTICALE SUR LE COTE AVANT

(30) Priorität: 11.11.1996 DE 29619481 U
(43) Veröffentlichungstag der Anmeldung: 25.08.1999
(73) Patentinhaber: SIEMENS AKTIENGESELLSCHAFT, 80333 München (DE)
(72) Erfinder: KURRER, Siegfried, D-90449 Nürnberg (DE); BILLENSTEIN, Ernst, D-91593 Burgbernheim (DE); KÖRBER, Werner, D-91282 Betzenstein (DE)
(86) Internationale Anmeldenummer: DE9702591
(87) Internationale Veröffentlichungsnummer: WO9821921

(56) Entgegenhaltungen:
- DE-A- 4 128 449
- DE-C- 4 034 772
- DE-U- 8 813 844
- FR-A- 1 578 231
- "Genormtes Gehäusesystem" G.I.T. FACHZEITSCHRIFT FÜR DAS LABORATORIUM, Bd. 16, Nr. 10, Oktober 1972, Seiten 1194-1198, XP002058689

## Beschreibung

Baugruppenträger dienen bekanntlich zur Aufnahme von sogenannten Steckbaugruppen, welche auf einer Leiterplatte aufgebrachte elektrische Schaltkreise und Bauelemente enthalten. Die Leiterplatten sind in einer in der Regel größeren Anzahl senkrecht nebeneinander stehend mit Hilfe von eingerasteten Führungsschienen in den Baugruppenträger eingeschoben. Zur frontseitigen Abdeckung weist jede Steckbaugruppe eine sogenannte Frontplatte auf. Die Frontplatten von senkrecht nebeneinander liegenden Steckbaugruppen bilden eine nahezu durchgehende Abdeckung auf der Frontseite des Baugruppenträgers.

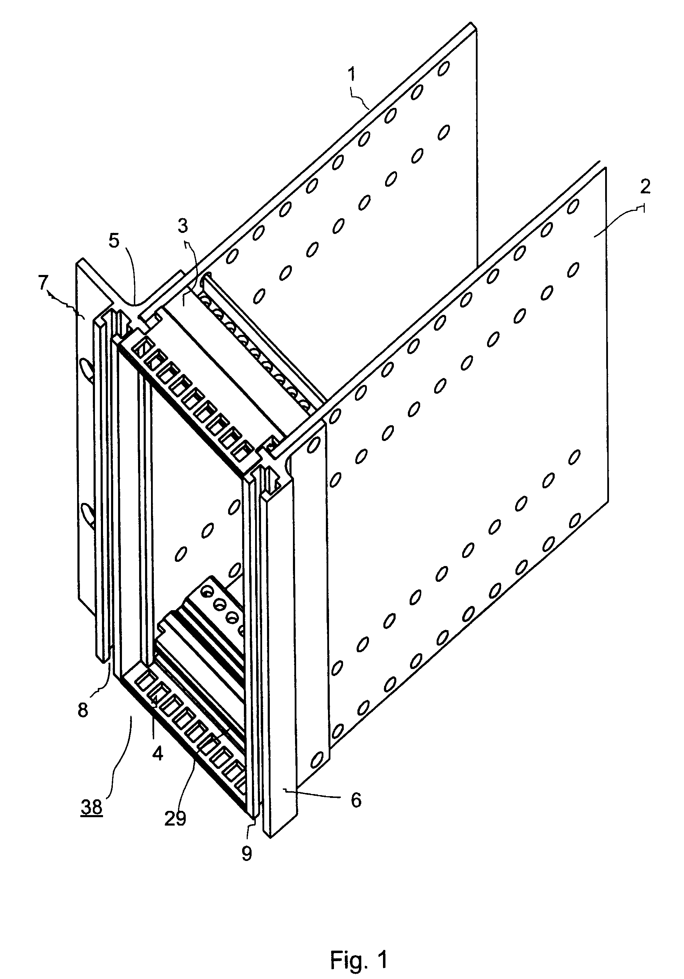

Ein Baugruppenträger weist gemäß der beispielhaften Darstellung in Figur 1 an dessen Frontseite 38 zumindest je eine obere und untere Querschiene 3,4 und je eine linke und rechte vertikale Eckprofilleiste 5,6 auf. Querschienen 3,4 und Eckprofilleisten 5,6 sind zu einem Rahmen verbunden. In der Regel sind an den Eckprofilleisten 5,6 noch Seitenwandbleche 1,2 zur seitlichen Abdeckung eingeschobener Steckbaugruppen angebracht.

Die Querschienen 3,4 weisen in der Regel nach außen auf die Frontseite 38 des Baugruppenträgers gerichtete horizontale Montagenuten auf. Im Beispiel der Figur 1 ist an der unteren Querschiene 4 eine derartige Montagenut 29 sichtbar. In dieser Nut können Haltemittel, wie z.B. Gewindeschienen, Käfigmuttern und dergleichen gelagert werden. In diesen Haltemitteln können wiederum externe Befestigungsmittel, wie z.B. Schrauben, gehalten werden. Mit den Befestigungsmitteln sind in den Baugruppenträger eingebrachte Komponenten an der Frontseite 38 fixierbar. So werden z.B. in den Baugruppenträger eingeschobene Steckbaugruppen an deren Ober- und Unterkante über Schrauben, welche durch deren Frontplatten hindurch bis in die horizontalen Montagenuten der oberen und unteren Querschienen reichen, über darin eingelegte Befestigungsmittel an dem Baugruppenträger fixiert.

Eine derartige Ausführung ist z.B. aus der FR-A-1 578 231 bekannt.

Aus der EP-A-0 262 450 ist ein Mehrzweck- Tischgehäuse aus zwei gleichen Seitenteilen und einem Ober- und Unterteil bekannt. Dabei weisen die Seitenteile auf den Innenseiten in gleichen Abständen zueinander angeordnete und vertikal durchgehend verlaufende T- Nuten auf. Ferner verfügen sogenannte Eckteile über aufeinander gerichtete T- Nuten. In diese kann z.B. eine flache Rückwand eingeschoben werden. Eine vergleichbare Anordnung ist auch aus der EP-B-0 338 339 bekannt.

Es tritt nun in der Praxis zunehmend die Anforderung auf, weitere Komponenten, Teile, Abdeckungen und dergleichen an der Frontseite eines Baugruppenträgers anwendungsabhängig anbringen zu können. Dabei ergibt sich das Problem, daß die sich an sich über die gesamte Breite eines Baugruppenträgers erstreckenden horizontalen Montagenuten in den oberen und unteren Querschienen von den Enden der Frontplatten eingeschobener Steckbaugruppen abgedeckt werden, und dann zur Aufnahme von weiteren Haltemitteln nicht mehr zugänglich sind.

Der Erfindung liegt die Aufgabe zugrunde, einen Baugruppenträger der oben genannten Art derart weiter auszubilden, daß erweiterte Befestigungsmöglichkeiten insbesondere für externe Zusatzteile an der Frontseite des Baugruppenträgers zur Verfügung stehen.

Die Aufgabe wird gelöst mit dem im Anspruch 1 angegebenen Baugruppenträger. Weitere Ausführungsformen der Erfindung sind in den Unteransprüche angegebenen.

Die Erfindung wird an Hand von in den nachfolgend kurz angeführten Figuren dargestellten Ausführungsbeispielen näher erläutert. Dabei zeigt
- FIG 1 :: eine bevorzugte Ausführungsform der Erfindung, bei der vorteilhaft an den beiden Eckprofilleisten eines Baugruppenträgers vertikale Montagenuten angeformt sind,
- FIG 2 :: beispielhaft den Querschnitt durch die linke Eckprofilleiste des Baugruppenträgers von Figur 1,
- FIG 3 :: beispielhaft den Querschnitt durch die rechte Eckprofilleiste des Baugruppenträgers von Figur 1,
- FIG 4 :: beispielhaft einen in eine vertikale Montagenut einlegbaren Halteklotz zur Fixierung externer Bauteile,
- FIG 5 :: einen beispielhaften Baugruppenträger gemäß der Erfindung, dessen Frontseite über einen bevorzugt schwenkbar in der vertikalen Montagenut einer Eckprofilleiste gelagerten Abdeckkasten vollständig abdeckbar ist,
- FIG 6 :: einen beispielhaften Baugruppenträger gemäß der Erfindung, dessen obere und untere Querschiene über je einen in den vertikalen Montagenuten an den beiden Eckprofilleisten gehaltenen Abdeckkasten abdeckbar sind,
- FIG 7 :: einen beispielhaften Baugruppenträger gemäß der Erfindung, bei dem ein Haltebügel über einen Halteklotz in der vertikalen Montagenut an der linken Eckprofilleiste angebracht ist, und
- FIG 8 :: einen beispielhaften Baugruppenträger gemäß der Erfindung, bei dem die vertikalen Montagenuten an den beiden Eckprofilleisten über bevorzugt beschriftbare Abdeckblenden verschließbar sind.

Bei dem in Figur 1 dargestellten Baugruppenträger weist die Frontseite 38 zumindest je eine obere und untere Querschiene 3, 4 und je eine linke und rechte vertikale Eckprofilleiste 5, 6 auf. Die Querschienen und Eckprofilleisten sind miteinander verbunden und bilden somit die Frontseite 38 des in Figur 1 dargestellten Baugruppenträgers. Über diese Frontseite können in der Figur 1 aus Gründen der Übersicht nicht dargestellte Steckbaugruppen senkrecht stehend in den Baugruppenträger eingeschoben werden. Erfindungsgemäß ist an mindestens einer der vertikalen Eckprofilleisten eine vertikale Montagenut bevorzugt einteilig angeformt. Bei der in Figur 1 dargestellten, bevorzugten Ausführung ist an den beiden vertikalen Eckprofilleisten 5 und 6 quasi gegenüberliegend ein Paar von zwei vertikalen Montagenuten 8, 9 angeformt. Hiermit ist eine besonders stabile Halterung von insbesondere zusätzlichen Bauteilen an der Frontseite des Baugruppenträgers möglich.

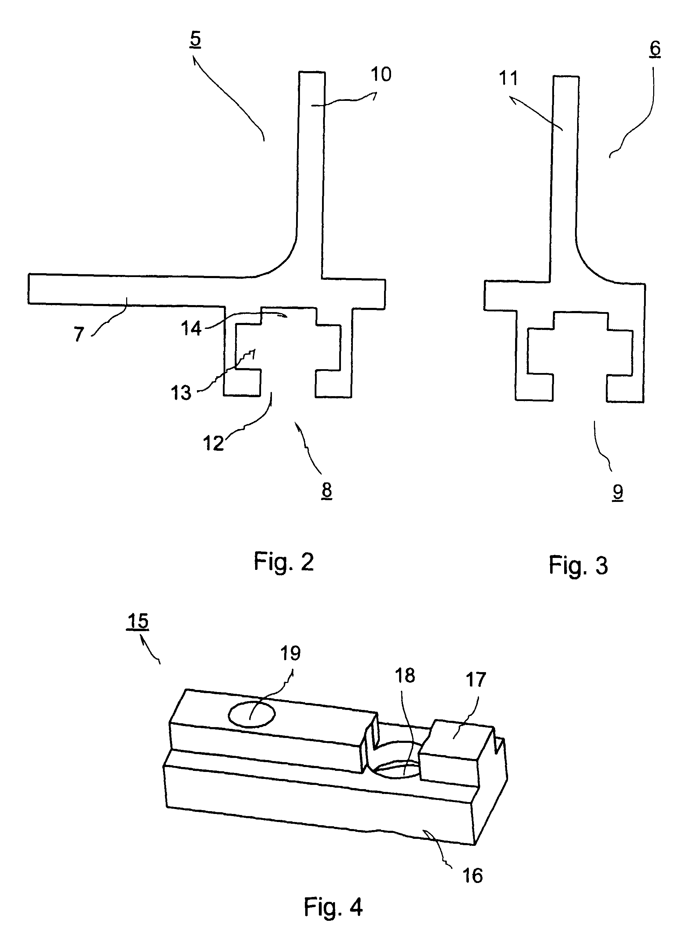

Eine bevorzugte Ausführungsform von vertikalen Montagenuten gemäß der Erfindung ist im Querschnitt in den Figuren 2 und 3 dargestellt. Dabei zeigt Figur 2 die vertikale Montagenut 8 an der linken Eckprofilleiste 5 von Figur 1, und Figur 3 die vertikale Montagenut 9 an der rechten Eckprofilleiste 6 von Figur 1. Die Eckprofilleisten 5,6 weisen dabei je eine nach hinten in das Innere des Baugruppenträgers abgehende hintere Montageleisten 10, 11 auf, an die Seitenwandbleche 1,2 gemäß der Darstellung von Figur 1 montierbar sind. Die linke Eckprofilleiste 5 weist zusätzlich einen um ca. 90 Grad zur hinteren Montageleiste 10 abgewinkelten Montageflansch 7 auf. Hierüber kann der Baugruppenträger z.B. in einem Schaltschrank montiert werden. Die vorteilhaft einteilig an den Eckprofilleisten 5,6 angeformten vertikalen Montagenuten 8,9 weisen jeweils einen zur Frontseite 38 des Baugruppenträgers gerichteten, verengten Aufnahmeschlitz 12 und jeweils eine dahinter liegende, erweiterte Haltenut 13 auf. In dieser Haltenut können diverse Haltemittel, wie z.B. Gewindeschienen, Käfigmuttern und dergleichen gelagert werden. In diese können wiederum externe Befestigungsmittel, wie z.B. Schrauben, gehalten werden. Mit den Befestigungsmitteln sind an der Frontseite 38 des Baugruppenträger eingebrachte Zusatzkomponenten fixierbar. Vorteilhaft ist hinter der erweiterten Haltenut 13 noch eine sogenannte verengte Ausweichnut 14 angeordnet, in die längere Schraubbolzen ausweichen können.

Als Befestigungsmittel sind besonders sogenannte Halteklötze geeignet, welche in die vertikale Montagenut eingelegt und mit Hilfe von z.B. externen Schrauben darin verklemmbar sind. In Figur 4 ist eine vorteilhafte Ausführungsform eines Halteklotzes 16 für externe Teile dargestellt. Der Grundkörper 16 des Halteklotzes weist eine der vertikalen Montagenut entsprechende Querschnittsform auf. Im Beispiel der Figur 4 hat der Halteklotz einen T-förmigen Querschnitt, wobei der Grundkörper 16 in der erweiterten Haltenut 13 und der Rückensteg 17 in dem verengten Aufnahmeschlitz 12 einer vertikalen Montagenut zu liegen kommt. Der Halteklotz 15 kann mit Hilfe einer Halteschraube, welche in eine Gewindebohrung 19 eingedreht werden kann, in beliebig anwendungsabhängig ausgewählten vertikalen Positionen in einer vertikalen Montagenut fixiert werden. Ferner ist eine Montageöffnung 18 vorhanden, mittel der externe Bauteile über zusätzliche Montageschrauben an dem Halteklotz fixierbar sind.

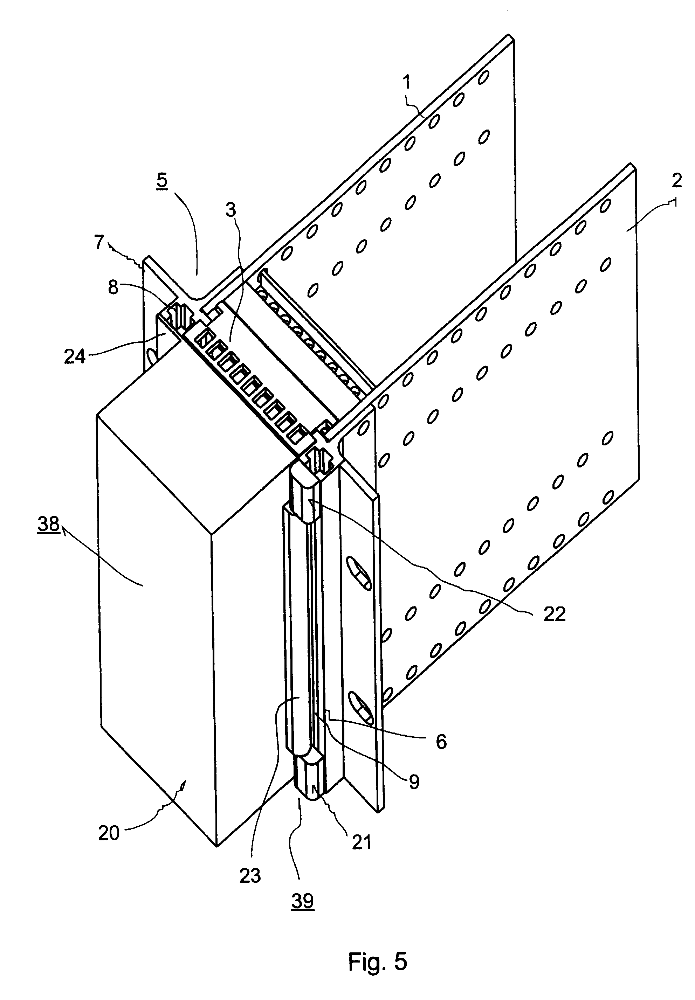

Am Beispiel der in den Figuren 5 bis 8 dargestellten Baugruppenträger werden nachfolgend vorteilhafte Ergänzungen derselben mit externen Bauteilen erläutert, welche über Montagemittel fixiert werden, die in mindestens eine vertikale Montagenut an einer Eckprofilleiste eingreifen.

So ist in Figur 5 ein Baugruppenträger dargestellt, dessen gesamte Frontseite 38 von einem Abdeckkasten 20 überspannt wird. Hiermit können die Frontplatten von darunterliegenden Steckbaugruppen vollständig z.B. gegen Schmutz, Feuchtigkeit, elektromagnetische Einstrahlung und unberechtigten Eingriff geschützt werden. Dieser ist mittels Haltemitteln, z.B. Schrauben, in einer oder beiden vertikalen Montagenuten 8, 9 an den Eckprofilleisten 5 oder 6 fixierbar. Bei der in Figur 5 dargestellten Ausführung ist der Abdeckkasten 20 schwenkbar. Hierzu weist der Abdeckkasten 20 an einer Vertikalseite eine Halteleiste 23 auf, welche in einem unteren und oberen Scharnier 21,22 drehbar gelagert ist. Die Scharniere 21,22 sind dabei in der vertikalen Montagenut 9 an der rechten Eckprofilleiste 6 angebracht, bevorzugt mit Hilfe der am Beispiel der Figur 4 erläuterten Halteklötze 15. Bei der in Figur 5 dargestellten Ausführung wird somit die vertikale Montagenut 8 an der linken Eckprofilleiste 5 zur Halterung der Abdeckung 20 nicht benötigt. Diese unbenutzte vertikale Montagenut 8 ist somit vorteilhaft durch eine an der linken Seite des Abdeckkastens befindliche vertikale Abschlußkante 24 abgedeckt.

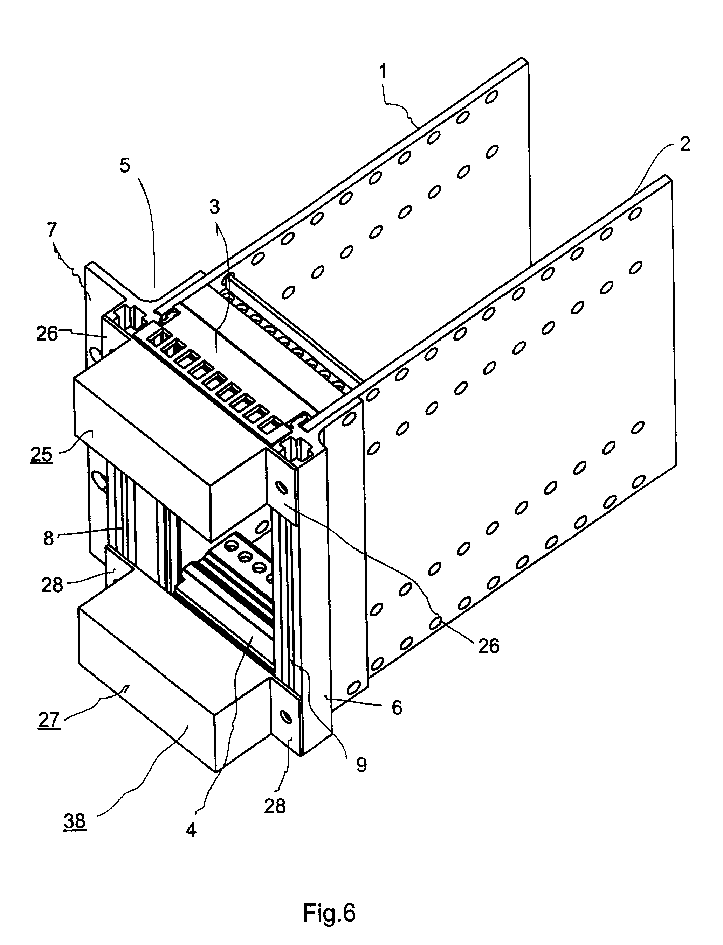

Im Beispiel der Figur 6 ist eine weitere Ausführung eines gemäß der Erfindung gestalteten Baugruppenträgers dargestellt. Dieser weist sowohl einen oberen als auch einen unteren Abdeckkasten 25, 26 auf, welche jeweils die obere und die untere Querschiene 3, 4 an der Frontseite 38 überspannen. Der obere und der untere Abdeckkasten 25, 26 können über Montagemittel, welche über jeweils beidseitig angebrachte Flansche 26, 28 in die vertikalen Montagenuten 8,9 der beiden Eckprofilleiste 5,6 eingreifen, fixierbar. Mit den oberen und unteren Abdeckkästen 25, 26 können z.B. an den oberen und unteren Enden von in den Baugruppenträger eingeschobenen Steckbaugruppen befindliche Hebel- und Ziehgriffe in der Art einer Summenverriegelung gegen versehentliche oder unberechtigte Benutzung gesichert werden.

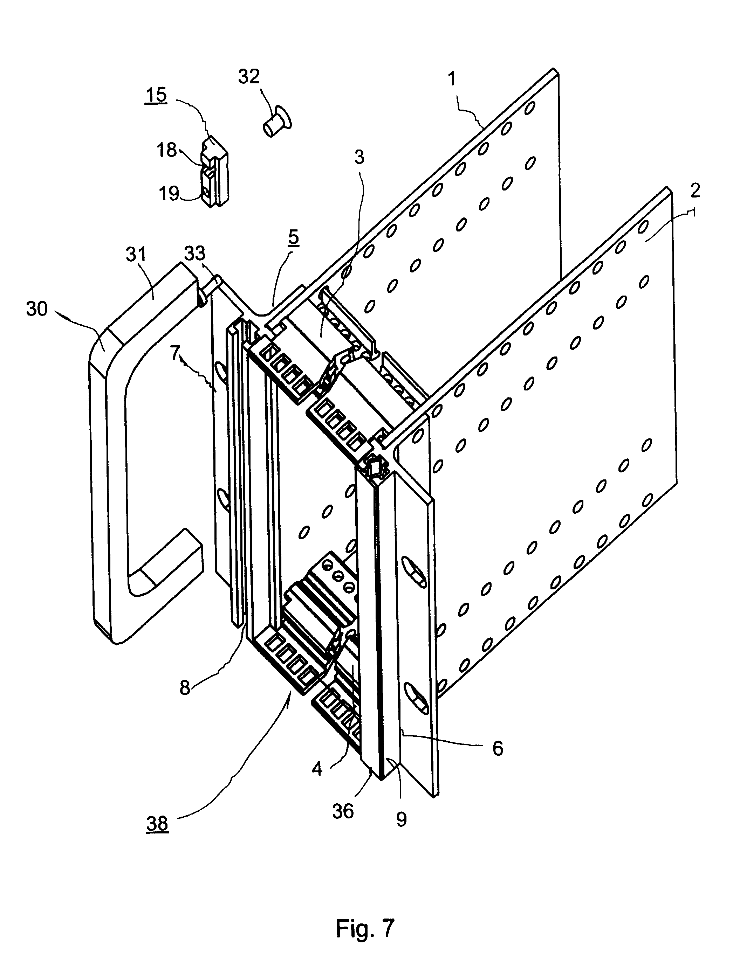

Bei dem in Figur 7 dargestellten Beispiel ist ein Haltebügel 30 in der vertikalen Montagenut 8 an der linken Eckprofilleiste 5 des Baugruppenträgers angebracht. Die Fixierung erfolgt vorteilhaft über zwei Halteklötze, welche jeweils mit dem oberen und unteren Schenkel des Haltebügels 30 verbunden und anschließend in die vertikale Montagenut 8 von einer Seite eingeschoben sind. Im Beispiel der Figur 7 sind die zur Montage des oberen Schenkels 31 des Haltebügels 30 benötigten Teile zur besseren Übersicht im nicht eingebauten Zustand einzeln dargestellt. Dabei dient eines Schraube 32 nach Durchgriff durch die Öffnung 18 zur Halterung des Halteklotzes 15 an der Stirnseite des oberen Schenkels 31. Nach erfolgter Einschiebung der so verbundenen Teile in die vertikale Montagenut 8 können diese über eine weitere Schraube 33, welche in eine Gewindenut 19 in den Halteklotz 15 eingreift, in der Montagenut 8 verklemmt werden.

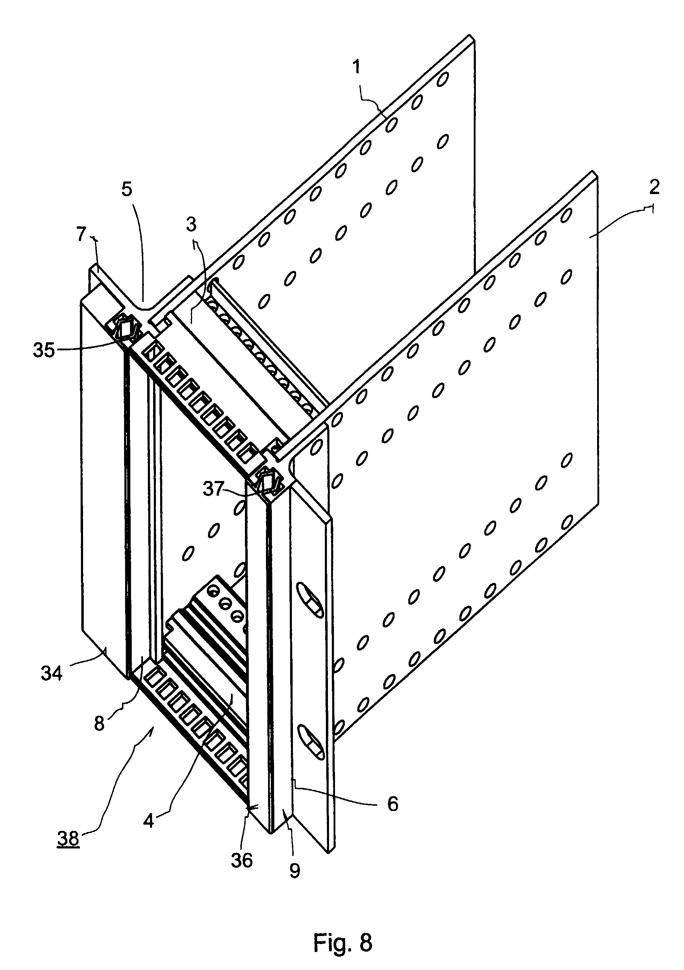

Gemäß einer weiteren, im Beispiel der Figur 7 bereits dargestellten Ausführungsform können unbenutzte vertikale Montagenuten an einem Baugruppenträger mit einer Abdeckblende zumindest vorübergehend verschlossen werden. So ist in Figur 7 die vertikale Montagenut 9 über eine darin eingeklemmte Abdeckblende 36 verschlossen. Bei dem in Figur 8 dargestellten Beispiel sind beide vertikale Montagenuten 8,9 an den Eckprofilleisten 5,6 mit Abdeckblenden 34,36 verschlossen. Dabei weisen die Abdeckblenden 34 bzw. 36 jeweils auf der Rückseite federartige Krallen 35 bzw. 37 auf, welche in der jeweiligen vertikalen Montagenut 8 bzw. 9 verklemmbar ist. Vorteilhaft können die Abdeckblenden (34,36) zusätzlich Mittel zur Anbringung von Markierungen aufweisen. Diese Mittel können z.B. in Form von vertikal übereinander liegend auf der Frontseite einer Abdeckblende angeformten Stegen ausgeführt sein, hinter welche Etiketten einschiebbar sind.

Der Vorteil der Erfindung liegt darin, daß mit den seitlich der Frontseite 38 angeordneten vertikalen Montagenuten eine vielseitig verwendbare Befestigungsmöglichkeit für unterschiedlichste zusätzliche, insbesondere mechanische Komponenten zur Verfügung steht. Diese kann völlig unabhängig von den herkömmlichen Befestigungsmöglichkeiten, insbesondere von den horizontalen Montagenuten an den unteren und oberen Querschienen, und ohne Beeinträchtigung von deren Funktionalität zusätzlich benutzt werden.

## Patentansprüche

1. Baugruppenträger, dessen Frontseite (38) zumindest je eine obere und untere Querschiene (3,4) und je eine linke und rechte vertikale Eckprofilleiste (5,6) aufweist, **dadurch gekennzeichnet**, daß an mindestens einer vertikalen Eckprofilleiste (5,6) eine vertikale, zur Frontseite (38) des Baugruppenträgers gerichtete Montagenut (8,9) angeformt ist.

2. Baugruppenträger nach Anspruch 1, wobei die vertikale Montagenut (8,9) einen zur Frontseite (38) gerichteten, verengten Aufnahmeschlitz (12) und eine dahinter liegende, erweiterte Haltenut (13) aufweist (Figuren 2, 3).

3. Baugruppenträger nach einem der vorangegangenen Ansprüche, mit einem Halteklotz (16) für externe Teile, z.B. einen Haltebügel (30), welcher eine der vertikalen Montagenut entsprechende Querschnittsform (16,17) aufweist und in anwendungsabhängig ausgewählten vertikalen Positionen in der Montagenut (8,9) fixierbar ist (Figuren 4, 7).

4. Baugruppenträger nach Anspruch 3, wobei der Halteklotz (16) erste Schraubmittel (18) zur Anbringung von externen Teilen (30) und zweite Schraubmittel (19) zur Verklemmung in der vertikalen Montagenut (8,9) aufweist (Figuren 4, 7).

5. Baugruppenträger nach einem der vorangegangenen Ansprüche mit einem die gesamte Frontseite (38) überspannenden Abdeckkasten (20), welcher in der vertikalen Montagenut (9) einer Eckprofilleiste (6) fixierbar ist (Figur 5).

6. Baugruppenträger nach Anspruch 5, wobei der schwenkbare Abdeckkasten (20) an einer Vertikalseite (39) mindestens eine Halteleiste (23) aufweist, die an mindestens einem Scharnier (21,22) drehbar gelagert ist, welches in der vertikalen Montagenut (9) einer Eckprofilleiste (6) fixierbar ist (Figur 5).

7. Baugruppenträger nach einem der Ansprüche 1 bis 4, mit einem oberen und/oder unteren Abdeckkasten (25,26), welcher die obere und/oder untere Querschiene (3,4) an der Frontseite (38) überspannt und in der vertikalen Montagenut (9) von mindestens einer Eckprofilleiste (6) fixierbar ist (Figur 6).

8. Baugruppenträger nach einem der vorangegangenen Ansprüche mit mindestens einer Abdeckblende (34,36), welche in der mindestens einen vertikalen Montagenut (8,9) fixierbar ist (Figuren 7, 8).

9. Baugruppenträger nach Anspruch 8, wobei die Abdeckblende (34,36) auf der Rückseite federartige Krallen (35,37) aufweist, welche in einer vertikalen Montagenut (8,9) verklemmbar ist (Figuren 7, 8).

10. Baugruppenträger nach Anspruch 8 oder 9, wobei die Abdeckblende (34,36) Mittel zur Anbringung von Markierungen aufweist (Figuren 7, 8).

## Claims

1. Mounting rack, the front side (38) of which has at least, in each case, one upper and one lower transverse rail (3, 4) and, in each case, one left-hand and one right-hand vertical profiled corner strip (5, 6), characterised in that a vertical mounting groove (8, 9) that is directed towards the front side (38) of the mounting rack is pre-formed on at least one vertical profiled corner strip (5, 6).

2. Mounting rack according to claim 1, wherein the vertical mounting groove (8, 9) has a narrowed receiving slot (12) that is directed towards the front side (38) and a widened retaining groove (13) lying behind this (Figures 2, 3).

3. Mounting rack according to one of the preceding claims, having a retaining block (16) for external parts, for example a loop-type handle (30), which block has a cross-sectional form (16, 17) that corresponds to the vertical mounting groove and which can be fixed in the mounting groove (8, 9) in vertical positions selected as a function of the application (Figures 4, 7).

4. Mounting rack according to claim 3, wherein the retaining block (16) has first screw means (18) for fitting external parts (30), and second screw means (19) for fastening in the vertical mounting groove (8, 9) (Figures 4, 7).

5. Mounting rack according to one of the preceding claims having a covering box (20) that spans the whole front side (38) and which can be fixed in the vertical mounting groove (9) of a profiled corner strip (6) (Figure 5).

6. Mounting rack according to claim 5, wherein the covering box (20), which can be swivelled, has on one vertical side (39) at least one retaining strip (23) which is rotatably mounted on at least one hinge (21, 22) which can be fixed in the vertical mounting groove (9) of a profiled corner strip (6) (Figure 5).

7. Mounting rack according to one of claims 1 to 4, having an upper and/or lower covering box (25, 26) that spans the upper and/or lower transverse rail (3, 4) on the front side (38) and can be fixed in the vertical mounting groove (9) of at least one profiled corner strip (6) (Figure 6).

8. Mounting rack according to one of the preceding claims having at least one covering screen (34, 36) which can be fixed in the at least one vertical mounting groove (8, 9) (Figures 7, 8).

9. Mounting rack according to claim 8, wherein the covering screen (34, 36) has on the rear side spring-like claws (35, 37) which can be fastened tightly in a vertical mounting groove (8, 9) (Figures 7, 8).

10. Mounting rack according to claim 8 or 9, wherein the covering screen (34, 36) has means for the provision of markings (Figures 7, 8).

## Revendications

1. Châssis équipé, dont le côté (38) avant comporte au moins un rail (3, 4) transversal respectif supérieur et inférieur et une baguette (5, 6) profilée angulaire verticale respective de gauche et de droite, **caractérisé** en ce qu'une rainure (8, 9) de montage verticale, dirigée vers le côté (38) avant du châssis équipé, est formée sur au moins une baguette (5, 6) profilée angulaire verticale.

2. Châssis équipé suivant la revendication 1, dans lequel la rainure (8, 9) de montage verticale comporte une fente (12) réceptrice rétrécie, dirigée vers le côté (38) avant, et, en arrière de cette fente, une rainure (13) de maintien élargie (figures 2, 3).

3. Châssis équipé suivant l'une des revendications précédentes, comportant une cale (15) de maintien pour des pièces externes, par exemple pour un étrier (30) de maintien, cale qui possède une forme (16, 17) de section correspondant à la rainure de montage verticale et qui peut être immobilisée dans la rainure (8, 9) de montage dans des positions verticales choisies en fonction de l'utilisation (figures 4, 7).

4. Châssis équipé suivant la revendication 3, dans lequel la cale (15) de maintien comporte des premiers moyens (18) de vissage pour l'installation de pièces (30) externes et des seconds moyens (19) de vissage pour le serrage dans la rainure (8, 9) de montage verticale (figures 4, 7).

5. Châssis équipé suivant l'une des revendications précédentes, comportant une boîte (20) de recouvrement qui recouvre la totalité du côté (38) avant et qui peut être immobilisée dans la rainure (9) de montage verticale d'une baguette (6) profilée angulaire (figure 5).

6. Châssis équipé suivant la revendication 5, dans lequel la boîte (20) de recouvrement pivotante comporte sur un côté (39) vertical au moins une baguette (23) de maintien, qui est montée à rotation sur au moins une charnière (21, 22) qui peut être immobilisée dans la rainure (9) de montage verticale d'une baguette (6) profilée angulaire (figure 5).

7. Châssis équipé suivant l'une des revendications 1 à 4, comportant une boîte (25, 27) de recouvrement supérieure et/ou inférieure, qui recouvre le rail (3, 4) transversal supérieur et/ou inférieur sur le côté (38) avant et qui peut être immobilisée dans la rainure (9) de montage verticale d'au moins une baguette (6) profilée angulaire (figure 6).

8. Châssis équipé suivant l'une des revendications précédentes, comportant au moins un cache (34, 36), qui peut être fixé dans la ou les rainures (8, 9) de montage verticales (figures 7, 8).

9. Châssis équipé suivant la revendication 8, dans lequel le cache (34, 36) comporte sur le côté arrière des crampons (35, 37) élastiques, qui peuvent être bloqués par serrage dans une rainure (8, 9) de montage verticale (figures 7, 8).

10. Châssis équipé suivant la revendication 8 ou 9, dans lequel le cache (34, 36) comporte des moyens pour apposer des marquages (figures 7, 8).
